# EUROPEAN PATENT APPLICATION

(11) **EP 2 437 306 A1**
(43) Date of publication of application: **04.04.2012**
(21) Application number: 10780216.7
(22) Date of filing: 18.05.2010
(51) Int. Cl.: H01L 31/04

(54) **SUBSTRATE FOR COMPOUND SEMICONDUCTOR SOLAR CELL**

(30) Priority: 28.05.2009 JP 2009129610
(71) Applicant: Toyo Kohan Co., Ltd., Tokyo 102-8447 (JP)
(72) Inventor: OKAMURA, Hiroshi, Kudamatsu-shi Yamaguchi 744-8611 (JP); YAMANO, Hirofumi, Kudamatsu-shi Yamaguchi 744-8611 (JP); MATSUBARA, Masanobu, Kudamatsu-shi Yamaguchi 744-8611 (JP); NISHIYAMA, Shigeyoshi, Kudamatsu-shi Yamaguchi 744-8611 (JP)
(74) Representative: Berryman, Natalia Grace
(86) International application number: PCT/JP2010/003329
(87) International publication number: WO 2010/137255

(57) **Abstract**

Provided is a substrate for a compound semiconductor solar cell, wherein the substrate maintains excellent elasticity even after high-temperature process is performed for forming a thin film. The substrate for a compound semiconductor solar cell is formed of a steel sheet, and a Cr layer having a coating quantity of 300 to 8000mg/m² is formed on a surface of the steel sheet on a side where a solar cell layer is laminated to the steel sheet. One specific embodiment of substrate is a substratewhere a Cr layer having a coating quantity of 500 to 3000mg/m² is formed on a surface of the steel sheet on a side where the solar cell layer is laminated to the steel sheet, and a film forming temperature of the solar cell layer is below 550°C. Another specific embodiment of substrate is a substrate where a Cr layer having a coating quantity of 2000 to 8000mg/m² is formed on a surface of the steel sheet on a side where the solar cell layer is laminated to the steel sheet, and a film forming temperature of the solar cell layer exceeds 800°C. Still another specific embodiment of substrate is a substrate where a Cr layer having a coating quantity of 2000 to 5000mg/m² is formed on a surface of the steel sheet on a side where the solar cell layer is laminated to the steel sheet, and a film forming temperature of the solar cell layer is 550°C or above and 800°C or below. Further, the content of Mn in a steel strip is 2wt% or less, and the content of Fe in the steel strip is 98wt% or less.

## Description

### TECHNICAL FIELD

Thepresent invention relates to a substrate for a compound semiconductor solar cell having flexibility.

### BACKGROUND ART

Conventionally, as a substrate for a compound semiconductor solar cell having a flexibility such as, for example, a solar cell of a CuInSe₂ (CIS) type or Cu (In, Ga) Se₂ (CIGS) type, a metal strip has been proposed (patent document 1). As a metal strip, stainless steel is usually used.
A metal strip described in patent document 1 has a film including an insulation layer doped with one kind of alkali metal or a mixture of plural kinds of alkali metals, a material of the metal strip has a thermal expansion coefficient of 12×10⁻⁶K⁻¹ within temperature range of 0 to 600°C, the insulation layer includes at least one kind of oxide layer, and the oxide layer is formed of any one kind of dielectric oxide selected from a group consisting of Al₂O₃, TiO₂, HfO₂, Ta₂O₅, Nb₂O₅ and a mixture of these oxides, and is preferably formed of Al₂O₃ and/or TiO₂.
Further, with respect to a substrate for a compound semiconductor solar cell, it has been known that when Fe or other elements which constitute substrate components diffuse into a solar cell layer, conversion efficiency is lowered. In view of the above, there has been known a technique where a diffusion preventing layer which suppresses the diffusion of substrate elements into the solar cell layer is formed on a substrate.
Patent document 2 describes a solar cell where a barrier layer made of a thin conductor, an extremely thin insulation material or the like, a back contact layer made of molybdenum or the like, a p type semiconductor layer and the like are formed on a substrate made of glass, metal, ceramics, plastics or the like.

### Prior Art Document

### Patent Document

Patent document 1: JP-A-2007-502536
Patent document 2: JP-T-2008-520103

### SUMMARY OF THE INVENTION

### PROBLEMS THAT THE INVENTION IS TO SOLVE

However, in patent document 1, the specific constitution of the diffusion preventing layer is not clearly disclosed.
Further, in an actual manufacturing process, although a film forming step for a compound semiconductor solar cell includes a high-temperature treatment step, it is not revealed whether or not the step exhibits a diffusion preventing function under specific conditions in the step. Under such circumstances, there exists a drawback that a kind of substrate by which a compound semiconductor solar cell can be manufactured without lowering power generation efficiency is indefinite.
Further, in the solar cell described in patent document 2, the barrier layer is formed by sputtering method. However, such a sputtering process has a drawback that an installation cost is pushed up so that a raw material used for manufacturing solar cells cannot be offered at a low cost.
In view of such circumstances, the present invention has clearly designated a specific substrate which is effective for the manufacture of a compound semiconductor solar cell which includes high-temperature heat treatment as a step thereof.
That is, it is an object of the present invention to provide a substrate for a compound semiconductor solar cell where, on a surface of a steel strip which maintains excellent elasticity even after a high temperature process at the time of forming a thin film of the compound semiconductor solar cell, a film layer capable of suppressing thermal diffusion and intrusion of an element contained in the steel strip which causes lowering of cell conversion efficiency into a thin film layer is formed by electrolytic plating.

### MEANS FOR SOLVING THE PROBLEMS

(1) In a substrate for a compound semiconductor solar cell according to the present invention, the substrate is formed of a steel sheet, and a Cr layer having a coating quantity of 300 to 8000mg/m² is formed on a surface of the steel sheet on a side where a solar cell layer is laminated to the steel sheet.
(2) In the substrate for a compound semiconductor solar cell having the constitution (1), the substrate is formed of a steel sheet, a Cr layer having a coating quantity of 500 to 3000mg/m² is formed on a surface of the steel sheet on a side where the solar cell layer is laminated to the steel sheet, and a film forming temperature of the solar cell layer is below 550°C.
(3) In the substrate for a compound semiconductor solar cell having the constitution (1), the substrate is formed of a steel sheet, a Cr layer having a coating quantity of 2000 to 8000mg/m² is formed on a surface of the steel sheet on a side where the solar cell layer is laminated to the steel sheet, and a film forming temperature of the solar cell layer exceeds 800°C.
(4) In the substrate for a compound semiconductor solar cell having the constitution (1), the substrate is formed of a steel sheet, a Cr layer having a coating quantity of 2000 to 5000mg/m² is formed on a surface of the steel sheet on a side where the solar cell layer is laminated to the steel sheet, and a film forming temperature of the solar cell layer is 550°C or above and 800°C or below.
(5) In the substrate for a compound semiconductor solar cell having any one of the constitutions (1) to (4), the content of Mn in a steel strip is 2wt% or less.
(6) In the substrate for a compound semiconductor solar cell having any one of the constitutions (1) to (4), the content of Fe in the steel strip is 98wt% or less.

### ADVANTAGEOUS EFFECTS OF THE INVENTION

The present invention provides the substrate which can prevent the diffusion of an impurity element into the substrate which lowers power generation efficiency into a solar cell layer by clearly designating the film constitution of a diffusion barrier layer.
Further, the present invention provides an inexpensive material with high productivity by adopting an electrolytic plating method as a method for forming the diffusion barrier layer.

### BRIEF DESCRIPTION OF THE DRAWINGS

Fig. 1 is an explanatory view schematically showing a cross section of a substrate for a compound semiconductor solar cell according to the present invention.
Fig. 2 is a graph showing a result of measurement of elements on a surface of the substrate after heat treatment (550°C×30 min).
Fig. 3 is a graph showing a result of measurement of elements on a surface of the substrate after heat treatment (800°C×15 min).

### MODE FOR CARRYING OUT THE INVENTION

A substrate for a compound semiconductor solar cell according to the present invention is a flexible substrate for a compound semiconductor solar cell. The substrate is formed of a steel sheet (steel strip), and a Cr layer having a coating quantity of 300 to 8000mg/m² is formed on a surface of the steel sheet on a side where a solar cell layer is laminated to the steel sheet.
The Cr layer constitutes a diffusionbarrier layer capable of suppressing the diffusion of elements such as Fe, Ni, Mn, Si and A1 which are harmful in conversion efficiency into the solar cell layer even in a high temperature process at the time of forming a thin film, and the Cr layer is formed by electrolytic treatment.
It is desirable that a Cr layer is also formed on a back surface side of the substrate as a corrosion resistance layer.
The steel strip may also be a surface treated steel sheet to which plating of Ni, Zn, Sn or the like is applied.

### <Diffusion barrier layer>

As the diffusion barrier layer capable of suppressing the diffusion of elements such as Fe, Ni, Mn, Si and Al which are harmful in conversion efficiency into the solar cell layer even in a high temperature process at the time of forming a thin film into the solar cell layer, the formation of a Cr layer can be named.
A thickness of the Cr layer on a light collection surface side is set to 300 to 8000mg/m². This is because a manufacturing process of the compound semiconductor solar cell includes a step of treating the substrate at a high temperature of 500°C or above and hence, it is necessary to set a thickness of the diffusion barrier layer to at least 300mg/m². On the other hand, even when the Cr layer having a thickness exceeding 8000mg/m² is formed, such a diffusion suppression effect is saturated, and a cost is also pushed up. Accordingly, an upper limit of the thickness of the Cr layer is set to 8000mg/m².
For example, in the heat treatment performed after forming a thin film on the substrate, when the heat treatment includes high-temperature treatment at 550°C, it is preferable to set the film thickness of the Cr layer to approximately 500 to 5000mg/m². When the film thickness of the Cr layer exceeds 5000mg/m², an Fe diffusion preventing effect is lowered. The reason is that, in the case where heat treatment is performed within a temperature range of approximately 550°C, when the Cr plating layer is thick, cracks occur in the plating layer due to thermal stress thus lowering an Fe diffusion preventing effect.
Further, when the heat treatment includes high-temperature treatment at 800°C or above, it is preferable to set the film thickness of the Cr layer to approximately 2000 to 8000mg/m².
When the Cr layer has the thickness of approximately 2000 to 5000mg/m², so long as heat treatment is performed within a range of 550 to 800°C, the Cr layer exhibits an effective diffusion preventing function.
Further, by taking into account a fact that solar cells are installed outdoors, it is desirable to provide a treated layer having corrosion resistance also on a side of the substrate opposite to the light collection surface side, that is, on a non-light-collecting surface side. It is sufficient that the treated layer having corrosion resistance has, when the treated layer is a Cr layer, a thickness of 80 to 500mg/m², and preferably 100 to 200mg/m².

### <Steel strip>

It is necessary for a steel strip which constitutes a base of the substrate to exhibit a low thermal expansion coefficient (TCE) for preventing the occurrence of peeling or cracks in a laminated Cr layer. Accordingly, a linear expansion coefficient (TCE) of the steel strip is desirably set to 16×10⁻⁶/K or less at a temperature range of 0 to 800°C.
To form the film on the steel strip by heat treatment at a temperature within a range of 500 to 800°C it is also necessary to impart sufficient heat resistance to the steel strip to be used. Further, to prevent a component contained in the steel strip from diffusing into the solar cell layer thus causing the deterioration of a cell performance, a steel strip material which satisfies the prevention of deterioration contains following components as inevitable components.
That is, the steel strip contains, as components thereof, C≤0.2% (% being mass (wt)%, the same definition being applicable in this specification), Si≤0.5%, Mn≤2.0%, P≤0.06%, S≤0.04%, Ti≤0.15% or Nb≤0.1%, Fe≤98% and unavoidable impurities.

Here, reasons for limiting main elements contained in the steel strip are explained.
C is an important element for the steel strip to acquire strength after forming a solar cell layer as a film. However, when the content of C is excessively large, a rolling load at the time of hot rolling and cold rolling is increased and hence, productivity is impeded due to the degradation of a shape or the like whereby an upper limit of C is set to 0.20%.
With respect to Si, although not particularly designated, when the content of Si is excessively large in the same manner as Mn, Si causes the increase of a load at the time of cold rolling, the degradation of a shape, the reduction of passing property in a continuous annealing step and the like thus lowering productivity. Accordingly, in the present invention, an upper limit value of the content of Si is set to 0.5%.
Mn is, in the same manner as C, an element necessary for the steel strip to acquire high strength after the formation of the solar cell layer as a film. However, when the content of Mn is excessively large, there exists a possibility that power generation efficiency of the solar cell is lowered or a rolling load is increased and hence, an upper limit of the content of Mn is set to 2.0%.
P is a component which makes crystal grains fine and increases strength of a cold-rolled steel sheet. Accordingly, the addition of P at a fixed rate is desirable. On the other hand, P segregates in a crystal grain boundary thus making the steel strip brittle and hence, the content of P is set to 0.06% or less.
S is an impurity component which causes red brittleness during hot rolling and hence, it is desirable that the content of S is as small as possible. However, the inclusion of S into the steel strip from a raw material or the like cannot be completely prevented, and desulphurization during the step is also limited and hence, the retention of S to some extent cannot be avoided. Red brittleness caused by a small amount of residual S can be reduced by Mn and hence, an upper limit value of the content of S is set to 0.04%.
Both elements Ti and Nb form carbonitride and hence, Ti and Nb have an effect of making crystal grains fine thus enhancing strength of the steel strip. However, when either of the elements is contained excessively in the steel strip, carbonitridebecomes coarse and hence, a strength enhancing effect becomes saturated. Further, a recrystallization temperature in continuous annealing is also elevated thus pushing up a cost. Accordingly, the contents of Ti and Nb are set to a range of Ti≤0.15% and a range of Nb≤0.1% respectively, and the steel strip contains either one or both of Ti and Nb.
Fe lowers power generation efficiency of a compound semiconductor solar cell and hence, the content of Fe is set to 98% or less.

### <Steel making>

A steel strip which constitutes the base of the substrate is manufactured in such a manner that raw materials are melted in a converter or an electric furnace, contents of molten steel are adjusted to the above-mentioned content ranges, the molten steel is formed into a slabmember, and the slabmember is subj ected to following steps thus forming the steel strip.

### <Hot rolling>

Firstly, the slab member with adjusted composition is formed into a sheet having a sheet thickness of 1.6 to 2.5mm by hot rolling. When the sheet thickness is small, a load at the time of hot rolling is increased and hence, a lower limit of a sheet thickness is set to 1.6mm. On the other hand, when the sheet thickness is large, a load at the time of cold rolling which is performed after hot rolling is increased and hence, an upper limit of a sheet thickness is set to 2.5mm.
In the hot rolling step, a heating temperature of the slab member having the above-mentioned composition ranges is set to 1100°C or above, and a winding temperature is set to 500°C or above. When the heating temperature of the slab member is below 1100°C, the positive decomposition and solid solution of N becomes insufficient and a hot rolling load is increased and hence, such a heating temperature is not preferable.
Further, the winding temperature is set to 500°C to 700°C. When the winding temperature is low, this induces the increase of strength of a hot-rolled steel sheet which is not favorable at the time of cold rolling and hence, a lower limit of the winding temperature is set to 500°C.
On the other hand, when the winding temperature exceeds 700°C, the formation of scales is accelerated at the time of hot rolling and hence, a load is increased at the time of descaling by pickling whereby an upper limit is set to 700°C.
The above-mentioned hot-rolled steel sheet is subjected to usual pickling, cold rolling and annealing, and is finally finished to a predetermined sheet thickness by cold rolling.

### <Thickness of substrate>

The substrate takes the configuration of a steel strip wherein a thickness of the substrate is 0.01 to 0.2mm, and desirably 0.025 to 0.05mm.

### <Surface roughness>

It is desirable that a surface of the substrate after Cr plating is finished is as smooth as possible and hence, the surface roughness of the substrate is an important parameter. As the surface roughness of the substrate, it is preferable to set Ra (surface roughness at center line), Rz (ten point height of irregularities) and Rmax (maximum height) to a range of Ra≤0.1µm, a range of Rz≤0.3µm, and a range of Rmax≤0.5µm respectively.
It is because when any one of a case where Ra exceeds 0.1µm, a case where Rz exceeds 0.3µm and a case where Rmax exceeds 0.5µm takes place, an Mo film which constitutes an electrode cannot be uniformly formed and hence, the steel strip is exposed whereby power generation efficiency of a compound semiconductor solar cell is deteriorated.

### <Yield stress>

Yield stress (Yp) of the substrate after Cr plating is desirably set to 200MPa or more.
Yield stress (Yp) is desirably 200 MPa or more even after heat hysteresis corresponding to a thin film forming heat treatment temperature of 550°C or above.
The reason is as follows. That is, no particular restriction is imposed on the substrate before the forming of a solar cell layer as a film and hence, the substrate is subj ected to hot working at a temperature of approximately 500 to 800°C whereby heat treatment is applied to the substrate so that the substrate is softened.
The substrate for a compound semiconductor solar cell of the present invention preferably has a sheet thickness of 0.2mm or less and, more preferably, 0.025 to 0.05mm. Since the substrate is extremely thin to be used as a substrate, the working and handling of the compound semiconductor solar cell become difficult when the substrate is softened. Accordingly, the substrate desirablyhas yield stress of 300MPa or more and tensile strength of 400MPa or more before the film forming of the solar cell layer, and desirably has yield stress of 200MPa or more and tensile strength of 300MPa or more after the film forming of the solar cell layer.

### <Manufacturing method of substrate>

To maximize the flexibility of the solar cell, it is necessary to make the Cr layer firmly adhered to the steel strip.
For this end, cleaning treatment is applied to the steel strip before the laminating of the Cr layer. That is, firstly, to remove a residual oil component or the like which has a possibility of adversely influencing the efficiency of lamination treatment, the adhesion of the film and quality of the film, the steel strip is cleaned by a proper method.
Next, electrolytic plating treatment is applied to the steel strip in line.

### Condition of <electrolytic plating treatment>

The conditions of the electrolytic plating treatment are preferably as follows.
A sulfuric acid bath can be used as a plating bath, and a bath formed by adding a sulfuric acid (0.3g/L) to 30 to 250g/L of chromium oxide (CrO₃) can be named. Further, it is desirable to use various auxiliaries so as to cause the stable precipitation of metal chromium and chromium oxide.
As the auxiliaries, for example, NaF, a sulfuric acid (in the case of a sulfuric acid bath), ammonium fluoride and the like can be named.
Plating conditions are as follows.
Current density: 10 to 70A/dm², preferably 20 to 40A/dm² Bath temperature: 30 to 60°C, preferably 40 to 50°C pH: 1 or less (strong acid)

### Embodiment

### <Embodiment 1>

Firstly, a material having the adjusted composition containing 0. 06% C, 0.2% Si, 1.6% Mn, 0.012% P and 0.010% S is subjected to hot rolling and, thereafter, is subjected to cold rolling consisting of several steps with a recrystallization step interposed therebetween thus eventually manufacturing a cold-rolled steel strip having a thickness of approximately 0.1mm.
Specimens are prepared by applying Cr plating having thicknesses of 500, 1000, 1500, 2000, 3000, 5000 and 8000mg/m² to one-side surfaces (on a light collecting surface side) of the steel strips respectively and by applying Cr plating having a thickness of 200mg/m² to the-other-side surfaces (onanon-light collecting surface side).
To obtain the above-mentioned Cr plating having thicknesses of 500 to 8000mg/m² respectively, an electrolysis time is changed. For example, to obtain Cr plating having a thickness of 2000mg/m² on the steel sheet, plating treatment is performed with current density of 30A/dm² for 40 sec. Thereafter, the specimens are heated in vacuum. Heating temperature conditions are 550°C×30min and 800°C×15min respectively.
The surface roughness (Ra) of the substrate on a light collecting surface side to which Cr plating is applied is 0.05µm.

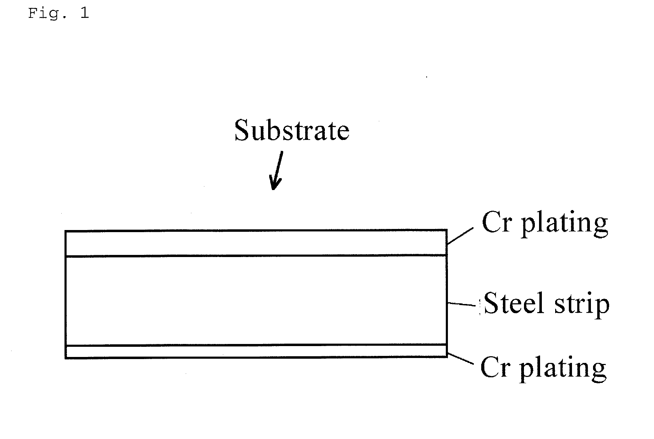

Fig. 1 is an explanatory view schematically showing a cross section of a substrate for a compound semiconductor solar cell.
Table 1 and Table 2 show values of a result of measurement of elements performed by an SIMS device with respect to a surface of the Cr plating after heat treatment is applied to the substrate according to the present invention.

**[Table 1]**

| treatment condition specimen | | treated material (550°C×30min) | |
|---|---|---|---|
| | | quantity of element (%) relative to SUS | |
| | | Fe | Mn |
| SUS430 | | 100 | 100 |
| quantity of chromium film of present invention (mg/m²) | 500 | 4 | 12 |
| | 1000 | 1 | 2 |
| | 1500 | 2 | 1 |
| | 2000 | 1 | 1 |
| | 3000 | 1 | 1 |
| | 5000 | 10 | 7 |
| | 8000 | 33 | 14 |

**[Table 2]**

| treatment condition specimen | | treated material (800°C×15min) | |
|---|---|---|---|
| | | quantity of element SUS | (%) relative to |
| | | Fe | Mn |
| SUS430 | | 100 | 100 |
| quantity of chromium film of present invention (mg/m²) | 500 | 46 | 143 |
| | 1000 | 42 | 158 |
| | 1500 | 28 | 103 |
| | 2000 | 4 | 19 |
| | 3000 | 1 | 1 |
| | 5000 | 1 | 1 |
| | 8000 | 0 | 1 |

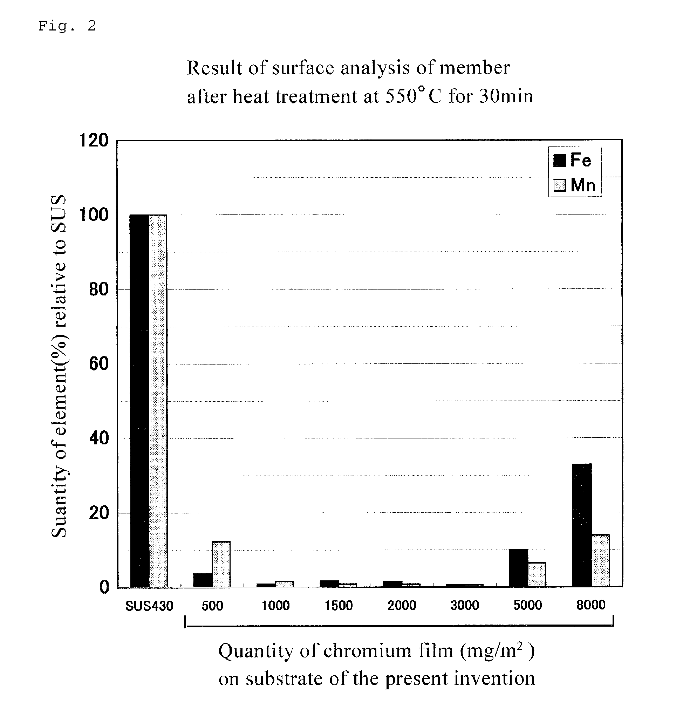

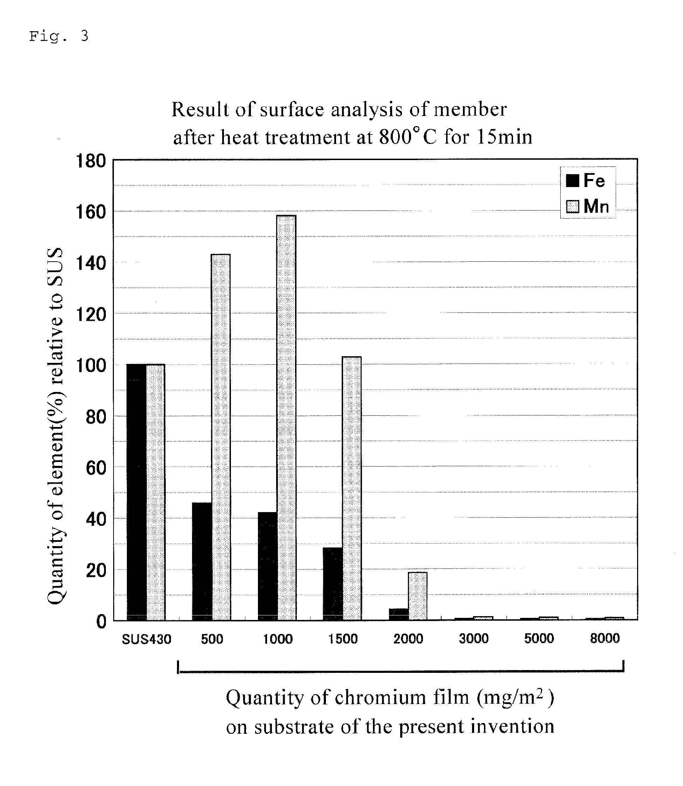

Further, Fig. 2 and Fig. 3 are graphs showing a result of measurement of elements (measured by an SIMS device) on a surface of the Cr plating after heat treatment is applied to the substrate according to the present invention.
The results shown in Fig. 2 and Fig. 3 are obtained by evaluating an Fe element diffusionpreventing effect in the steel strip which becomes a base of the substrate.
As can be understood from Fig. 2 and Fig. 3 which show the result of the evaluation, when the heat treatment is performed under the condition of 550°C×30min, compared to the comparison member (SUS430), according to the substrate of the present invention having a Cr plating thickness of 500mg/m² or more, a quantity of Fe on the surface of the substrate can be largely reduced and hence, the substrate of the present invention can acquire an Fe diffusion preventing effect (see Fig. 2).
Further, when the heat treatment is performed under the condition of 800°C×15min, in the case where the Cr plating thickness is set to 2000mg/m² or more, a quantity of Fe on the surface of the substrate can be largely lowered compared to a comparison member and hence, the substrate of the present invention can acquire an Fe element diffusion preventing effect (see Fig. 3).

### Industrial Applicability

According to the substrate for a compound semiconductor solar cell of the present invention, by clearly designating the film constitution of the diffusion barrier layer, the diffusion of an impurity element in a steel strip which causes lowering of power generation efficiency into the solar cell layer can be prevented. Further, by adopting an electrolytic plating method as a method for forming the diffusion barrier layer, productivity is increased and hence, an inexpensive material can be offered whereby industrial applicability of the present invention is extremely high.

## Claims

1. A substrate for a compound semiconductor solar cell, wherein the substrate is formed of a steel sheet, and a Cr layer having a coating quantity of 300 to 8000mg/m² is formed on a surface of the steel sheet on a side where a solar cell layer is laminated to the steel sheet.

2. The substrate for a compound semiconductor solar cell according to claim 1, wherein the substrate is formed of a steel sheet, a Cr layer having a coating quantity of 500 to 3000mg/m² is formed on a surface of the steel sheet on a side where the solar cell layer is laminated to the steel sheet, and a film forming temperature of the solar cell layer is below 550°C.

3. The substrate for a compound semiconductor solar cell according to claim 1, wherein the substrate is formed of a steel sheet, a Cr layer having a coating quantity of 2000 to 8000mg/m² is formed on a surface of the steel sheet on a side where the solar cell layer is laminated to the steel sheet, and a film forming temperature of the solar cell layer exceeds 800°C.

4. The substrate for a compound semiconductor solar cell according to claim 1, wherein the substrate is formed of a steel sheet, a Cr layer having a coating quantity of 2000 to 5000mg/m² is formed on a surface of the steel sheet on a side where the solar cell layer is laminated to the steel sheet, and a film forming temperature of the solar cell layer is 550°C or above and 800°C or below.

5. The substrate for a compound semiconductor solar cell according to any one of claims 1 to 4, wherein the content of Mn in a steel strip is 2wt% or less.

6. The substrate for a compound semiconductor solar cell according to any one of claims 1 to 4, wherein the content of Fe in the steel strip is 98wt% or less.
